# EUROPÄISCHE PATENTANMELDUNG

(11) **EP 2 854 175 A1**
(43) Veröffentlichungstag der Anmeldung: **01.04.2015**
(21) Anmeldenummer: 14176895.2
(22) Anmeldetag: 14.07.2014
(51) Int. Cl.: H01L 25/07, H01R 4/26, H01R 13/11

(54) **Leistungshalbleitereinrichtung**

(30) Priorität: 30.09.2013 DE 102013110818
(71) Anmelder: SEMIKRON Elektronik GmbH & Co. KG, 90431 Nürnberg (DE)
(72) Erfinder: Kulas, Hartmut, 90562 Heroldsberg (DE)

(57) **Zusammenfassung**

Die Erfindung betrifft eine Leistungshalbleitereinrichtung mit einem Leistungshalbleitermodul und einem elektrisch leitenden Laststromanschlusselement, wobei das Leistungshalbleitermodul Leistungshalbleiterbauelemente, die auf einer elektrisch leitenden strukturierten Leitungsschicht angeordnet sind, aufweist, wobei auf der Leitungsschicht ein elektrisch leitendes Laststromverbindungselement angeordnet ist, wobei das Laststromanschlusselement an einem ersten Endbereich des Laststromanschlusselement eine erste Kontaktfläche und eine federnde Kontaktzunge aufweist, wobei zwischen der Kontaktzunge und der ersten Kontaktfläche des Laststromanschlusselements ein erster Abschnitt des Laststromverbindungselements angeordnet ist, wobei die Kontaktzunge einen Druck auf den ersten Abschnitt des Laststromverbindungselements ausübt und den ersten Abschnitt des Laststromverbindungselements gegen die erste Kontaktfläche des Laststromanschlusselements drückt. Die Erfindung schafft eine Leistungshalbleitereinrichtung bei der ein Laststromanschlusselement langfristig zuverlässig mit einem Laststromverbindungselement elektrisch leitend verbunden ist, wobei die Verbindung zwischen Laststromanschlusselement und Laststromverbindungselement auf einfache Art und Weise ohne erheblichen Wärmeeintrag herstellbar ist.

## Beschreibung

Die Erfindung betrifft eine Leistungshalbleitereinrichtung.

Aus dem Stand der Technik bekannte Leistungshalbleitereinrichtungen weisen im Allgemeinen ein einzelnes oder mehrere Leistungshalbleitermodule auf, wobei das jeweilige Leistungshalbleitermodul ein Substrat aufweist auf dem Leistungshalbleiterbauelemente, wie z.B. Leistungshalbleiterschalter und Dioden angeordnet und mittels einer Leiterschicht des Substrats, sowie Bonddrähten und/oder einem Folienverbund miteinander elektrisch leitend verbunden sind. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor) vor.

Die auf dem Substrat angeordneten Leistungshalbleiterbauelemente sind dabei häufig elektrisch zu einer einzelnen oder mehreren sogenannten Halbbrückenschaltungen verschalten, die z.B. zum Gleich- und Wechselrichten von elektrischen Spannungen und Lastströmen verwendet werden.

Das jeweilige Leistungshalbleitermodul weist laststromführende Laststromverbindungselemente auf, welche mit dem Substrat elektrisch leitend verbunden sind. Zum weiteren führen der Lastströme weisen technikübliche Leistungshalbleitereinrichtungen, wie sie z.B. aus der DE 10 2011 076 323 A1 bekannt sind, Laststromanschlusselemente auf, die mit den Laststromverbindungselementen mittels einer elektrisch leitenden stoffschlüssigen Verbindung, wie z.B. einer Schweißverbindung oder einer kraftschlüssigen Verbindung miteinander elektrisch leitend verbunden sind. Die Laststromanschlusselemente dienen zum Anschluss von externen elektrische Leitungen an die Leistungshalbleitereinrichtungen.

Die Herstellung von stoffschlüssigen Verbindungen ist aber technisch aufwendig und im Allgemeinen mit einem nicht unerheblichen Wärmeeintrag verbunden, der zu Beschädigungen von Elementen der Leistungshalbleitereinrichtung führen kann.

Weiterhin ist häufig die Verbindung der Laststromanschlusselementen mit den Laststromverbindungselemente einer Schwingungs- und Temperaturwechselbelastung ausgesetzt, die längerfristig zum Versagen der Verbindung führen kann.

Es ist Aufgabe der Erfindung eine Leistungshalbleitereinrichtung zu schaffen bei der ein Laststromanschlusselement langfristig zuverlässig mit einem Laststromverbindungselement elektrisch leitend verbunden ist, wobei die Verbindung zwischen Laststromanschlusselement und Laststromverbindungselement auf einfache Art und Weise ohne erheblichen Wärmeeintrag herstellbar ist.

Diese Aufgabe wird gelöst durch eine Leistungshalbleitereinrichtung mit einem Leistungshalbleitermodul und einem elektrisch leitenden Laststromanschlusselement, wobei das Leistungshalbleitermodul Leistungshalbleiterbauelemente, die auf einer elektrisch leitenden strukturierten Leitungsschicht angeordnet sind, aufweist, wobei auf der Leitungsschicht ein elektrisch leitendes Laststromverbindungselement angeordnet ist, wobei das Laststromanschlusselement an einem ersten Endbereich des Laststromanschlusselements eine erste Kontaktfläche und eine federnde Kontaktzunge aufweist, wobei zwischen der Kontaktzunge und der ersten Kontaktfläche des Laststromanschlusselements ein erster Abschnitt des Laststromverbindungselements angeordnet ist, wobei die Kontaktzunge einen Druck auf den ersten Abschnitt des Laststromverbindungselements ausübt und den ersten Abschnitt des Laststromverbindungselements gegen die erste Kontaktfläche des Laststromanschlusselements drückt.

Vorteilhafte Ausbildungen der Erfindung ergeben sich aus den abhängigen Ansprüchen.

Es erweist sich als vorteilhaft, wenn die Kontaktzunge eine Kante aufweist, wobei der erste Abschnitt des Laststromverbindungselements zwischen der Kante und der ersten Kontaktfläche des Laststromanschlusselements angeordnet ist, wobei die Kontaktzunge einen Druck auf den ersten Abschnitt des Laststromverbindungselements ausübt und die Kante den ersten Abschnitt des Laststromverbindungselements gegen die erste Kontaktfläche des Laststromanschlusselements drückt, wobei die Kante sich in den ersten Abschnitt des Laststromverbindungselements eindrückt. Hierdurch wird ein besonders langfristig zuverlässiger elektrisch leitender Kontakt zwischen Laststromanschlusselements und Laststromverbindungselements erzielt.

Weiterhin erweist es sich als vorteilhaft, wenn das Laststromanschlusselement ein von der ersten Kontaktfläche des Laststromanschlusselements und von der Kontaktzunge beanstandet angeordnetes Nasenelement aufweist, wobei das Laststromverbindungselement zwischen dem Nasenelement und der ersten Kontaktfläche des Laststromanschlusselements angeordnet ist, wobei das Nasenelement zusammen mit der ersten Kontaktfläche des Laststromanschlusselements eine Führung für das Laststromverbindungselement ausbilden. Hierdurch wird auf einfache Art und Weise eine zuverlässige Führung für das Laststromverbindungselement geschaffen.

Weiterhin erweist es sich als vorteilhaft, wenn das Laststromanschlusselement an einem zweiten Endbereich eine zweite Kontaktfläche aufweist, da dann eine externe elektrische Leitung auf einfache Art und Weise mit dem Laststromanschlusselement elektrisch kontaktiert werden kann

Weiterhin erweist es sich als vorteilhaft, wenn durch die zweite Kontaktfläche ein Durchgangsloch verläuft, da dann eine externe elektrische Leitung auf einfache Art und Weise mit dem Laststromanschlusselement mittels einer Schraubverbindung verbunden werden kann.

Weiterhin erweist es sich als vorteilhaft, wenn das Laststromanschlusselement einstückig ausgebildet ist. Hierdurch wird ein besonders einfach aufgebaute sehr zuverlässige Realisierung des Laststromanschlusselements erzielt.

Weiterhin erweist es sich als vorteilhaft, wenn das Laststromanschlusselement in Form eines mehrfach gebogen Bleches vorliegt. Hierdurch wird ein besonders einfach aufgebaute sehr zuverlässige Realisierung des Laststromanschlusselements erzielt. Ein Ausführungsbeispiel der Erfindung ist in den Figuren dargestellt und wird im Folgenden näher erläutert. Dabei zeigen:
- FIG 1: eine perspektivische Ansicht einer erfindungsgemäßen Leistungshalbleitereinrichtung,
- FIG 2: eine gegenüber FIG 1 um 180° gedrehte perspektivische Ansicht einer erfindungsgemäßen Leistungshalbleitereinrichtung,
- FIG 3: eine Schnittansicht eines Leistungshalbleitermoduls,
- FIG 4: eine perspektivische Ansicht eines Laststromanschlusselements,
- FIG 5: eine weitere perspektivische Ansicht eines Laststromanschlusselements und
- FIG 6: eine Schnittansicht eines Laststromanschlusselements.

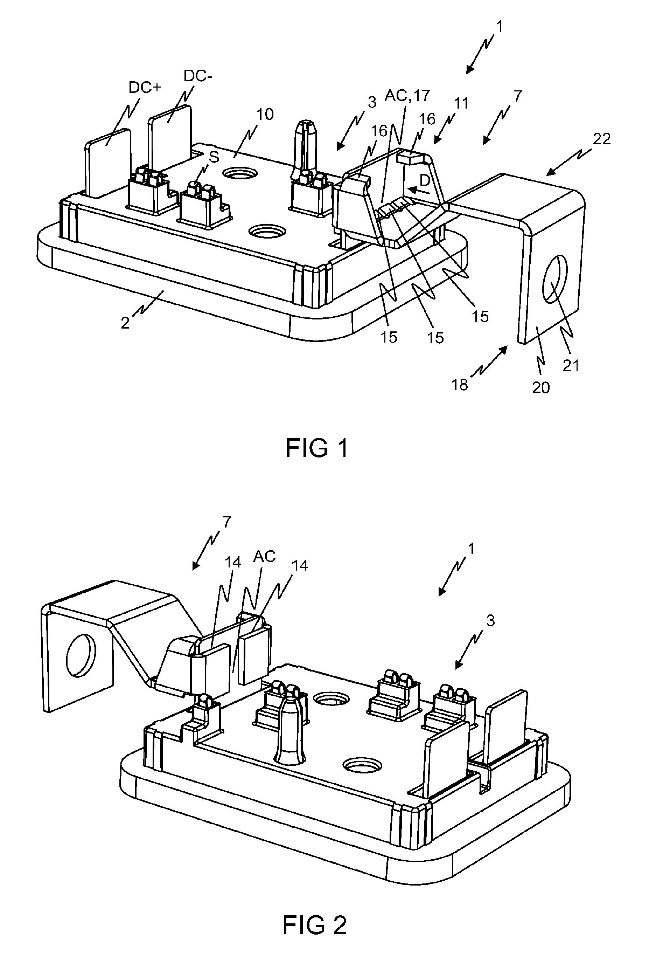

In FIG 1 und FIG 2 sind zwei perspektivische Ansichten einer erfindungsgemäßen Leistungshalbleitereinrichtung 1 dargestellt. Die Leistungshalbleitereinrichtung 1 weist ein Leistungshalbleitermodul 3 und ein elektrisch leitendes Laststromanschlusselement 7 auf, das im Rahmen des Ausführungsbeispiels zum elektrischen Anschluss des Leistungshalbleitermoduls 3 an eine externe elektrische Leitung, wie z.B. eine Stromschiene oder ein Kabel, dient. Die Leistungshalbleitereinrichtung 1 weist ein in FIG 1 und FIG 2 der Übersichtlichkeit halber nicht dargestelltes mit Ausnehmungen versehenes Leistungshalbleitereinrichtungsgehäuse auf, wobei das Laststromanschlusselement 7 durch eine Ausnehmung des Leistungshalbleitereinrichtungsgehäuses hindurch verläuft, so dass die externe elektrische Leitung außerhalb des Leistungshalbleitereinrichtungsgehäuses mit dem Laststromanschlusselement 7, z.B. mittels einer Schraubverbindung, verbunden werden kann.

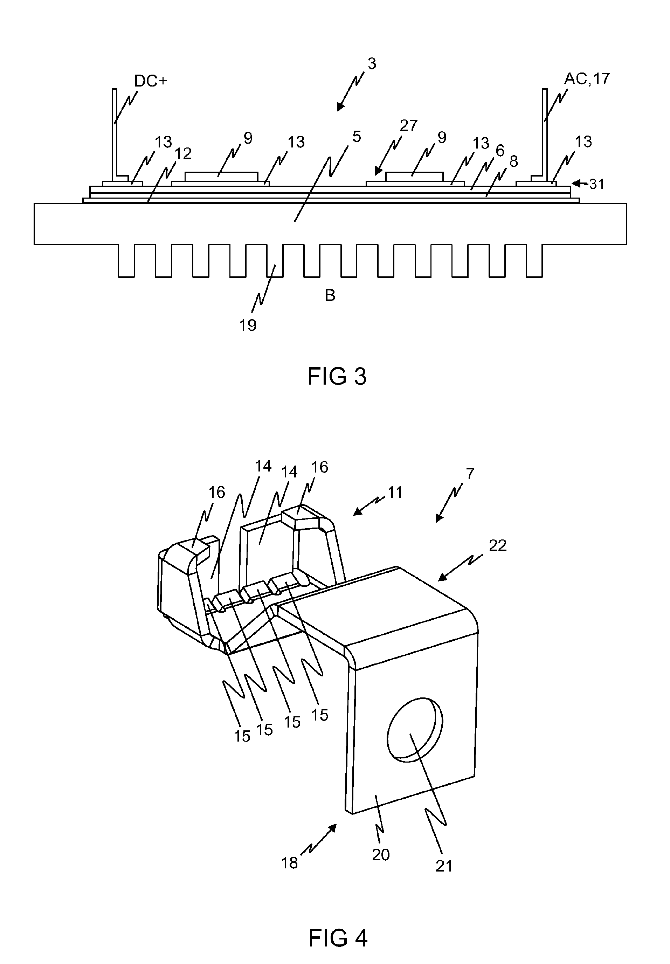

In FIG 3 ist eine Schnittansicht des Leistungshalbleitermoduls 3 dargestellt, wobei in FIG 3 nur die zum Verständnis der Erfindung wesentlichen Elemente des Leistungshalbleitermoduls 3 dargestellt sind. Das Leistungshalbleitermodul 3 weist Leistungshalbleiterbauelemente 9 auf, die auf einer elektrisch leitende Leiterbahnen 13 ausbildenden elektrisch leitenden strukturierten ersten Leitungsschicht 31 angeordnet sind. Die Leistungshalbleiterbauelemente 9 sind mit der ersten Leitungsschicht 31 bzw. mit den Leiterbahnen 13, vorzugsweise über eine Löt- oder Sintermetallschicht, elektrisch leitend verbunden. Weiterhin sind auf der ersten Leitungsschicht 31 elektrisch leitende Laststromverbindungselemente DC+, DC- und AC angeordnet. Die Laststromverbindungselemente DC+, DC- und AC sind mit der ersten Leitungsschicht 31 bzw. mit den Leiterbahnen 13, vorzugsweise über eine Löt- oder Sintermetallschicht, elektrisch leitend verbunden. Das jeweilige Leistungshalbleiterbauelement liegt vorzugweise in Form eines Leistungshalbleiterschalters oder einer Diode vor. Die Leistungshalbleiterschalter liegen dabei vorzugsweise in Form von Transistoren, wie z.B. IGBTs (Insulated Gate Bipolar Transistor) oder MOSFETs (Metal Oxide Semiconductor Field Effect Transistor) vor. Im Rahmen des Ausführungsbeispiels erzeugt das Leistungshalbleitermodul 3 aus einer zwischen den Laststromverbindungselementen DC+ und DC- eingespeisten Gleichspannung am Laststromverbindungselement AC eine Wechselspannung. Weiterhin weist das jeweilige Leistungshalbleitermodul 3 im Rahmen des Ausführungsbeispiels Steueranschlusselemente S auf, die elektrisch leitend mit den Steueranschlüssen der Leistungshalbleiterschalter des Leistungshalbleitermoduls 3 verbunden sind.

Weiterhin weist das Leistungshalbleitermodul 3 eine elektrisch nicht leitende Isolationsschicht 6 und eine Kühlplatte 5 auf, wobei die Isolationsschicht 6 zwischen den Leiterbahnen 13 und der Kühlplatte 5 angeordnet ist. Die erste Leitungsschicht 31 ist mit der Isolationsschicht 6 verbunden. Im Rahmen des Ausführungsbeispiels ist zwischen der Isolationsschicht 6 und der Kühlplatte 5 eine elektrisch leitende vorzugweise unstrukturierte zweite Leitungsschicht 8 angeordnet, die mit der Isolationsschicht 6 verbunden ist. Die Isolationsschicht 6 liegt vorzugsweise in Form eines Keramikkörpers vor. Die erste und zweite Leitungsschicht 31 und 8 und die Isolationsschicht 6 werden zusammen vorzugsweise durch ein Direct Copper Bonded Substrat 27 (DCB-Substrat) ausgebildet.

Es sei an dieser Stelle angemerkt, dass die erste und die zweite Leitungsschicht aus einer einzelnen Schicht oder auch aus mehreren übereinanderliegenden Schichten bestehen können. So kann die erste und/oder die zweite Leitungsschicht z.B. eine Kupferschicht aufweisen, die eine einzelne oder mehrere übereinanderliegende Beschichtungen, z.B. aus einem Edelmetall (z.B. Silber) oder aus einer Edelmetallverbindung aufweist, welche z.B. als Haftvermittlungsschichten und/oder Schutzschichten dienen können.

Die Kühlplatte 5 kann an Ihrer den Leistungshalbleiterbauelementen 9 zugewandten Seite mit einer einzelnen oder mehreren übereinanderliegende Schichten beschichtet sein, die z.B. jeweilig als Haftvermittlungsschicht und/oder als Schutzschicht dienen können und/oder dazu dienen können mechanische Spannungen zwischen Isolationsschicht 6 und der Kühlplatte 5, welche bei Temperaturänderungen, aufgrund unterschiedlicher Temperaturausdehnungskoeffizienten von Isolationsschicht 6 und Kühlplatte 5, auftreten können, zu reduzieren. Im Rahmen des Ausführungsbeispiels ist die Kühlplatte 5 an Ihrer der Isolationsschicht 6 zugewandten Seite mit einer Kupferschicht 12 beschichtet, die wiederum z.B. mit einer Beschichtung, insbesondere einer Edelmetallbeschichtung (z.B. Silber) beschichtet sein kann. Die Kupferschicht 12 ist zwischen Kühlplatte 5 und Isolationsschicht 6, und insbesondere zwischen Kühlplatte und zweiter Leitungsschicht 8 angeordnet. Die zweite Leitungsschicht 8 ist mit der Kühlplatte 5, vorzugsweise über eine Löt- oder Sintermetallschicht, direkt oder indirekt (falls die Kühlplatte an Ihrer den Leistungshalbleiterbauelementen zugewandten Seite mit einer einzelnen oder mehreren übereinanderliegenden Schichten beschichtet ist) verbunden. Die zweite Leitungsschicht 8 ist im Rahmen des Ausführungsbeispiels über eine Löt- oder Sintermetallschicht mit der Kupferschicht 12 verbunden.

Weiterhin sind im Rahmen des Ausführungsbeispiels die Leistungshalbleiterbauelemente 9 und die Laststromverbindungselemente DC+, DC-und AC über Bonddrähte und/oder einem Folienverbund miteinander elektrisch leitend verbunden, was der Übersichtlichkeit halber in FIG 3 nicht dargestellt ist.

Der Übersichtlichkeit halber sind in FIG 3 die Löt- oder Sintermetallschichten nicht dargestellt. Weiterhin sei angemerkt, dass die Dicke der Schichten und die Dicke der Leistungshalbleiterbauelemente nicht maßstabsgerecht dargestellt sind.

Es sei an dieser Stelle angemerkt, dass die Kühlplatte auch in Form eines Aluminiumkörpers eines Insulated Metal Substrats (IMS) vorliegen kann.

Die Kühlplatte 5 kann, wie beim Ausführungsbeispiel, an ihrer den Leitungshalbleiterbauelementen 9 abgewandten Seite B Kühlfinnen und/oder Kühlpins 19 aufweisen. Weiterhin kann die Kühlplatte 5 zum Anbringen der Kühlplatte an einen Kühlkörper Durchgangslöcher aufweisen.

Das Leistungshalbleitermodul 3 weist vorzugsweise eine die Leistungshalbleiterbauelemente 9 und das Substrat 27 abdeckendes Modulgehäuse 10 auf, wobei das Modulgehäuse 10 Ausnehmungen aufweist, durch die die Laststromverbindungselemente DC+, DC- und AC geführt sind.

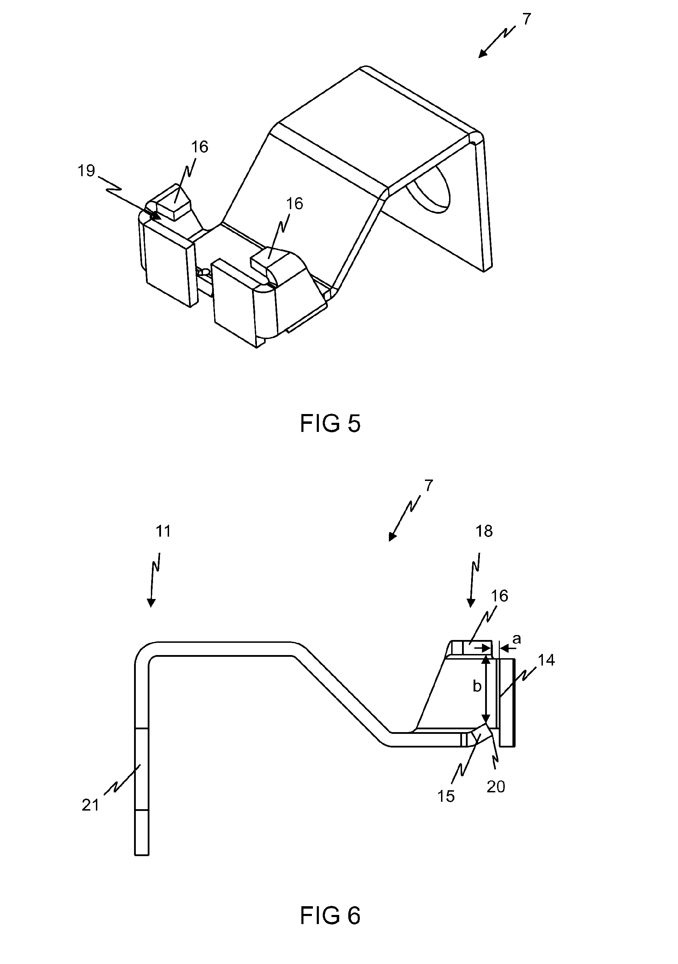

Die Leistungshalbleitereinrichtung 1 weist weiterhin, wie schon beschrieben, ein elektrisch leitendes Laststromanschlusselement 7 auf, das im Rahmen des Ausführungsbeispiels zum elektrischen Anschluss des Leistungshalbleitermoduls 3 an eine externe elektrische Leitung, wie z.B. eine Stromschiene oder ein Kabel, dient. FIG 1 und FIG 2 zeigen eine Ansicht in der das Laststromanschlusselement 7 mit dem Laststromverbindungselement AC elektrisch leitend verbunden ist. In den Figuren 4 bis 6 ist das Laststromanschlusselement 7 in verschiedenen Ansichten dargestellt.

Das Laststromanschlusselement 7 weist an einem ersten Endbereich 11 des Laststromanschlusselement 7 erste Kontaktflächen 14 und federnde Kontaktzungen 15 auf. Zur Verbindung des Laststromanschlusselements 7 mit dem Laststromverbindungselement AC wird der am ersten Endbereich 11 angeordnete Teil des Laststromanschlusselements 7 von oben auf das Laststromverbindungselement AC aufgedrückt. Hierbei werden die Kontaktzungen 15 aufgebogen und drücken in Richtung der ersten Kontaktflächen 14 des Laststromanschlusselements 7. Zwischen den Kontaktzungen 15 und den ersten Kontaktflächen 14 ist nach dem Aufdrücken des Laststromanschlusselements 7 auf das Laststromverbindungselement AC ein erster Abschnitt 17 des Laststromverbindungselements AC angeordnet. Die Kontaktzungen 15 üben einen Druck D (siehe FIG 1, wobei der Pfeil unter dem Bezugszeichen D die Druckrichtung angibt) auf den ersten Abschnitt 17 des Laststromverbindungselements AC aus und drücken den ersten Abschnitt 17 des Laststromverbindungselements AC gegen die ersten Kontaktflächen 14 des Laststromanschlusselements 7.

Die Kontaktzungen 15 weisen vorzugsweise jeweilig eine Kante 20 auf, wobei der erste Abschnitt 17 des Laststromverbindungselements AC zwischen den Kanten 20 der Kontaktzungen 15 und den ersten Kontaktflächen 14 angeordnet ist, wobei die Kontaktzungen 15 einen Druck D auf den ersten Abschnitt 17 des Laststromverbindungselements AC ausüben und die Kanten 20 den ersten Abschnitt 17 des Laststromverbindungselements AC gegen die ersten Kontaktflächen 14 des Laststromanschlusselements 7 drücken, wobei die Kanten 20 sich in den ersten Abschnitt 17 des Laststromverbindungselements AC eindrücken. Hierdurch wird ein besonders langfristig zuverlässiger schwingungsresistenter und temperaturwechselbeständiger elektrisch leitender Kontakt zwischen dem Laststromanschlusselement 7 und dem Laststromverbindungselement AC erzielt.

Das Laststromanschlusselement 7 weist im Rahmen des Ausführungsbeispiels von den ersten Kontaktflächen 14 des Laststromanschlusselements 7 und von den Kontaktzungen15 beanstandet angeordnete Nasenelemente 16 auf, wobei das Laststromverbindungselement AC zwischen den Nasenelementen 16 und den ersten Kontaktflächen 14 des Laststromanschlusselements 7 angeordnet ist, wobei die Nasenelemente 16 zusammen mit den ersten Kontaktflächen 14 des Laststromanschlusselements 7 eine Führung 19 für das Laststromverbindungselement AC ausbilden. Die Nasenelemente 16 weisen von den ersten Kontaktflächen 14 des Laststromanschlusselements 7 einen Abstand a auf und von den Kontaktzungen15 einen Abstand b auf. Der Abstand a ist dabei so bemessen, dass der Abstand a gleich oder geringfügig größer ist als die Dicke des Materials des ersten Abschnitts 17 des Laststromverbindungselements AC. Die Nasenelemente 16 verlaufen vorzugsweise senkrecht zu den ersten Kontaktflächen 14.

Das Laststromanschlusselement 7 weist vorzugsweise an einem zweiten Endbereich 11 des Laststromanschlusselements 7 eine zweite Kontaktfläche 20 auf, durch die vorzugsweise ein Durchgangsloch 21 verläuft. Die zweite Kontaktfläche 20 dient zur elektrischen Kontaktierung des Laststromanschlusselement 7 mit einer externen elektrische Leitung, wie z.B. einer Stromschiene oder einem Kabel, wobei die externe elektrische Leitung vorzugsweise mittels einer durch das Durchgangsloch 21 verlaufenden Schraubverbindung mit dem Laststromanschlusselement 7 verbunden wird.

Das Laststromanschlusselement 7 ist vorzugsweise einstückig ausgebildet und liegt vorzugsweise in Form eines mehrfach gebogen Bleches vor. Das Laststromanschlusselement 7 bzw. das Blech kann z.B. aus Kupfer bestehen.

Es sei an dieser Stelle angemerkt, dass in analoger Weise mittels des Laststromanschlusselements auch die Laststromverbindungselemente DC+ und DCmit einer jeweiligen externen elektrischen Leitung verbunden werden können.

Weiterhin sei angemerkt, dass die erfindungsgemäße Leistungshalbleitereinrichtung auch nur eine einzelne erste Kontaktfläche und/oder auch nur eine einzelne Kontaktzunge und/oder auch nur ein einzelnes Nasenelement aufweisen kann.

## Patentansprüche

1. Leistungshalbleitereinrichtung mit einem Leistungshalbleitermodul (3) und einem elektrisch leitenden Laststromanschlusselement (7), wobei das Leistungshalbleitermodul (3) Leistungshalbleiterbauelemente (9), die auf einer elektrisch leitenden strukturierten Leitungsschicht (31) angeordnet sind, aufweist, wobei auf der Leitungsschicht (31) ein elektrisch leitendes Laststromverbindungselement (AC) angeordnet ist, wobei das Laststromanschlusselement (7) an einem ersten Endbereich (11) des Laststromanschlusselements (7) eine erste Kontaktfläche (14) und eine federnde Kontaktzunge (15) aufweist, wobei zwischen der Kontaktzunge (15) und der ersten Kontaktfläche (14) des Laststromanschlusselements (7) ein erster Abschnitt (17) des Laststromverbindungselements (AC) angeordnet ist, wobei die Kontaktzunge (15) einen Druck auf den ersten Abschnitt (17) des Laststromverbindungselements (AC) ausübt und den ersten Abschnitt (17) des Laststromverbindungselements (AC) gegen die erste Kontaktfläche (14) des Laststromanschlusselements (7) drückt.

2. Leistungshalbleitereinrichtung nach Anspruch 1, **dadurch gekennzeichnet, dass** die Kontaktzunge (15) eine Kante (20) aufweist, wobei der erste Abschnitt (17) des Laststromverbindungselements (AC) zwischen der Kante (20) und der ersten Kontaktfläche (14) des Laststromanschlusselements (7) angeordnet ist, wobei die Kontaktzunge (15) einen Druck auf den ersten Abschnitt (17) des Laststromverbindungselements (AC) ausübt und die Kante (20) den ersten Abschnitt (17) des Laststromverbindungselements (AC) gegen die erste Kontaktfläche (14) des Laststromanschlusselements (7) drückt, wobei die Kante (20) sich in den ersten Abschnitt (17) des Laststromverbindungselements (AC) eindrückt.

3. Leistungshalbleitereinrichtung nach einem der vorhergehenden Ansprüche, **dadurch gekennzeichnet, dass** das Laststromanschlusselement (7) ein von der ersten Kontaktfläche (14) des Laststromanschlusselements (7) und von der Kontaktzunge (15) beanstandet angeordnetes Nasenelement (16) aufweist, wobei das Laststromverbindungselement (AC) zwischen dem Nasenelement (16) und der ersten Kontaktfläche (14) des Laststromanschlusselements (7) angeordnet ist, wobei das Nasenelement (16) zusammen mit der ersten Kontaktfläche (14) des Laststromanschlusselements (7) eine Führung (19) für das Laststromverbindungselement (AC) ausbilden.

4. Leistungshalbleitereinrichtung nach einem der vorhergehenden Ansprüche, **dadurch gekennzeichnet, dass** das Laststromanschlusselement (7) an einem zweiten Endbereich (18) eine zweite Kontaktfläche (20) aufweist.

5. Leistungshalbleitereinrichtung nach Anspruch 4, **dadurch gekennzeichnet, dass** durch die zweite Kontaktfläche (20) ein Durchgangsloch verläuft.

6. Leistungshalbleitereinrichtung nach einem der vorhergehenden Ansprüche, **dadurch gekennzeichnet, dass** das Laststromanschlusselement (7) einstückig ausgebildet ist.

7. Leistungshalbleitereinrichtung nach Anspruch 6, **dadurch gekennzeichnet, dass** das Laststromanschlusselement (7) in Form eines mehrfach gebogen Bleches vorliegt.
